# FASCICULE DE BREVET EUROPEEN

(11) **EP 0 480 815 B1**
(45) Date de publication et mention de la délivrance du brevet: **14.12.1994**
(21) Numéro de dépôt: 91402678.6
(22) Date de dépôt: 08.10.1991
(51) Int. Cl.: H03F 1/30, H03F 3/345

(54) **Amplificateur monobroche en circuit intégré**
Integrierte Verstärkerschaltung mit einziger Eingangssignalverbindung
Integrated amplifier circuit with one input signal connection

(30) Priorité: 09.10.1990 FR 9012438
(43) Date de publication de la demande: 15.04.1992
(73) Titulaire: SGS-THOMSON MICROELECTRONICS S.A., 94250 Gentilly (FR)
(72) Inventeur: Tournier, Christian, F-75116 Paris (FR)
(74) Mandataire: Schmit, Christian Norbert Marie

(56) Documents cités:
- EP-A- 0 236 525
- US-A- 3 886 464
- US-A- 4 038 607
- US-A- 4 045 747

## Description

L'invention concerne les circuits intégrés incorporant des amplificateurs.

La tendance actuelle est, avec le développement des technologies MOS et CMOS, à l'intégration de systèmes de plus en plus complexes regroupant sur la même puce de circuit intégré des fonctions tant logiques qu'analogiques.

Se posent alors des problèmes de diaphonie entre partie logique et partie analogique, c'est-à-dire de bruitage des fonctions analogiques par les signaux logiques qui transitent sur des conducteurs voisins.

La cause première de ce bruit est la présence de commutations de signaux logiques entre deux niveaux de tension relativement écartés l'un de l'autre. Ces commutations se transmettent, capacitivement ou inductivement, à des conducteurs voisins qu'ils perturbent. Le bruit ainsi engendré couvre un large spectre de fréquences puisque les transitions de niveau logique peuvent être très raides et les paliers de niveau logiques très plats.

Parmi les conducteurs perturbés, il y a par exemple les lignes d'alimentation (Vcc et Vss). Mais il peut y avoir d'autres éléments de circuit comme par exemple le substrat du circuit intégré lui-même : le potentiel du substrat subit alors l'influence du bruit, et cette influence se répercute sur le fonctionnement des transistors dont le canal est constitué par le substrat.

En particulier, dans les fonctions analogiques (amplificateurs par exemple), le bruit logique engendré par les fonctions logiques voisines peut entraîner une instabilité des tensions de référence internes au circuit, que ce soit la référence du substrat ou une tension d'alimentation, ou tout simplement le point de fonctionnement au repos d'un noeud de circuit.

Pour compenser ces instabilités, on est souvent obligé de prévoir des moyens de compensation. Par exemple, le moyen le plus fréquemment utilisé consiste à prévoir à l'extérieur du circuit intégré des sources de courant de référence (non bruitées), pour fournir les références non bruitées dont on a besoin. On utilise aussi parfois des configurations de circuit intégré dans lesquelles des alimentations séparées sont prévues pour la partie analogique et pour la partie logique du circuit, afin que les interférences soient minimisées.

Un des problèmes qu'on rencontre alors est l'augmentation du nombre de broches extérieures du circuit intégré. On sait qu'il est souhaitable de réduire autant que possible le nombre de broches extérieures d'un circuit intégré.

Un but de l'invention est de réaliser un amplificateur pour amplifier un signal analogique en provenance de l'extérieur d'un circuit intégré, qui :
- n'utilise qu'une seule broche du circuit en plus de deux broches d'alimentation (ces deux broches étant de toutes façons prévues pour le reste du circuit),
- fonctionne dans une bande de fréquences bruitée par des signaux logiques voisins,
- présente une bonne sensibilité (niveau d'entrée minimum de faible valeur), et un faible bruit de phase, et ait un point de polarisation stable en l'absence de signal d'entrée malgré le bruit présent sur les alimentations (autrement dit une bonne réjection de mode commun par rapport aux alimentations, malgré le fait que l'amplificateur ne soit pas différentiel puisqu'il n'aura qu'une broche d'entrée).

Ce type d'amplificateur s'avère nécessaire dans tous les systèmes où la phase du signal est importante et où pourtant le coût de réalisation doit rester faible (coût des broches en particulier). C'est le cas par exemple des boucles à verrouillage de phase.

Selon l'invention, on propose donc un amplificateur analogique en circuit intégré ayant une entrée connectée à une broche d'entrée du circuit intégré, l'amplificateur analogique étant alimenté par un premier conducteur d'alimentation et un deuxième conducteur d'alimentation communs à une partie logique et une partie analogique du circuit intégré, et comportant au moins un étage amplificateur, caractérisé en ce que les problèmes de perturbation du fonctionnement de l'amplificateur analogique par les bruits engendrés par la partie logique et transmis par les conducteurs d'alimentation communs sont éliminés par le montage suivant :
- un étage amplificateur comportant un inverseur constitué d'une paire de transistors MOS complémentaires avec un premier transistor MOS complémentaire et un deuxième transistor MOS montés en série, leurs grilles étant réunies ensemble à une entrée de l'étage amplificateur, leurs drains étant réunis ensemble à une sortie de l'étage amplificateur, l'étage amplificateur comportant en outre un troisième transistor MOS pour imposer un courant entrant dans l'inverseur et monté en séries entre le premier conducteur d'alimentation et la source d'un premier transistor MOS, et un quatrième transistor MOS pour imposer un courant sortant de l'inverseur et monté en série entre le deuxième conducteur d'alimentation et la source du deuxième transistor MOS,
- un étage de référence de courant comportant une première branche entre le premier et le deuxième conducteur d'alimentation, avec une résistance en série avec un cinquième transistor MOS monté en diode,
- et une deuxième branche avec un sixième transistor et un septième transistor montés en série entre le premier et le deuxième conducteur d'alimentation, le sixième transistor étant monté en miroir de courant pour imposer un courant de référence dans le septième transistor monté en diode,
- le troisièmes transistor et le quatrième transistor de l'étage amplificateur étant respectivement montés en miroir de courant par rapport au septième transistor MOS et du cinquième transistor MOS en sorte que le courant entrant imposé par le troisième transistor MOS soit égal au courant sortant imposé par le quatrième transistor MOS.

Une résistance de contre réaction est de préférence prévue entre les grilles réunies et les drains réunis des transistors de la paire complémentaire. Cette résistance est par exemple réalisée à l'aide de deux transistors complémentaires en parallèle dont les grilles sont reliées chacune respectivement à l'un des conducteurs d'alimentation.

L'amplificateur peut comporter deux étages en série comportant chacun une paire complémentaire et les transistors qui servent à les alimenter en courant (troisième et quatrième transistors). La résistance de contre réaction prévue de préférence sur le premier étage n'est pas nécessairement prévue sur le deuxième. Un troisième étage, avec ou sans résistance de contre-réaction, peut être prévu en plus. Ce troisième étage ne comporte pas nécessairement les troisième et quatrième transistors d'alimentation en courant, du fait que les niveaux de tension d'entrée qu'il reçoit après amplification dans les deux premiers étages sont suffisamment élevés.

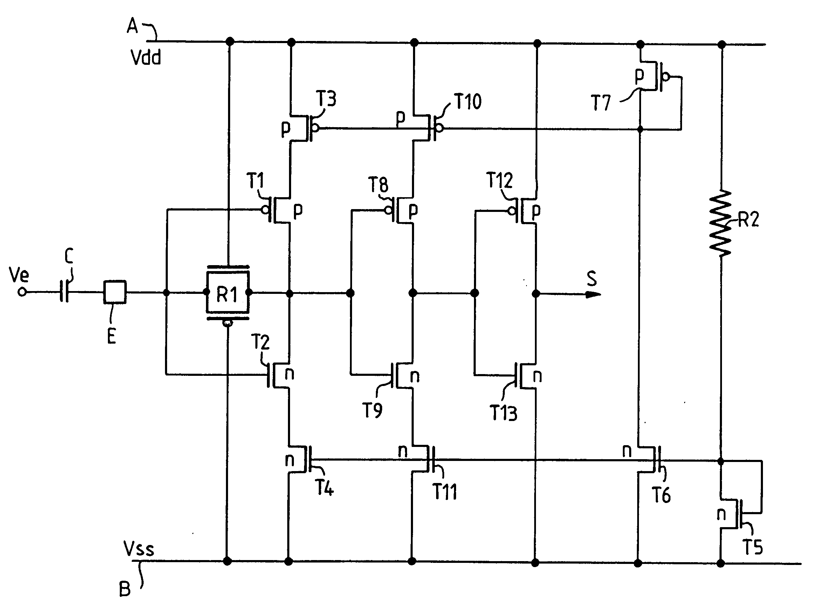

D'autres caractéristiques et avantages de l'invention apparaîtront à la lecture de la description détaillée qui suit et qui est faite en référence au dessin annexé dans lequel la figure unique représente un exemple détaillé de réalisation de l'invention.

L'amplificateur est alimenté en énergie par deux conducteurs d'alimentation A et B à des tensions respectives Vdd et Vss; par exemple Vdd est d'environ + 5 volts, Vss étant la référence de potentiel nul.

Une seule broche d'entrée E est nécessaire à l'amplificateur (pas de deuxième broche pour constituer une entrée différentielle, pas de broches pour y connecter des circuits de compensation extérieurs au circuit intégré).

Le signal d'entrée à amplifier, Ve, sera appliqué à cette entrée en principe à travers une capacité C extérieure au circuit intégré.

L'amplificateur représenté comprend plusieurs étages, le plus important selon l'invention étant le premier.

Le premier étage comporte une paire de transistors complémentaires T1 et T2 (type p et n respectivement) en série entre les conducteurs A et B. Les transistors sont reliés par leurs drains. Leurs grilles sont reliées ensemble à la broche d'entrée E (en principe directement).

La source de T1 est reliée à un troisième transistor T3 de même type (p), lui-même relié par ailleurs au conducteur A. Le troisième transistor constitue un transistor d'alimentation en courant de la paire complémentaire T1, T2. Le courant d'alimentation est entrant. La source de T2 est reliée à un quatrième transistor T4 de même type (n) lui-même relié par ailleurs au conducteur B. Le transistor T4 est également un transistor d'alimentation en courant de la paire complémentaire, le courant étant cette fois un courant sortant.

Comme on le verra, ces transistors sont commandés de manière que les courants qu'ils imposent dans la paire complémentaire soient identiques, c'est-à-dire que le courant entrant est égal au courant sortant, et ceci indépendamment des fluctuations de la tension d'alimentation qui peut être bruitée par des signaux logiques voisins.

Pour limiter le gain de l'étage amplificateur d'entrée ainsi constitué, une résistance R1 peut être prévue entre la sortie de cet étage (prise sur les drains des transistors T1 et T2) et l'entrée (prise sur les grilles réunies de ces transistors). Cette résistance peut être réalisée à partir de deux transistors complémentaires montés en parallèle, le transistor à canal P ayant sa grille reliée à Vss et le transistor à canal N ayant sa grille reliée à Vdd.

Pour la commande des troisième et quatrième transistors, on prévoit un circuit à miroirs de courant recopiant successivement des courants à partir d'un cinquième transistor T5 monté en diode (sa grille est reliée à son drain).

Le transistor T5 est relié en série avec une résistance R2, l'ensemble étant connecté entre les conducteurs A et B. Le transistor est polarisé en saturation. Il est parcouru par un courant qui est essentiellement lié à sa géométrie, c'est-à-dire à son rapport largeur/longueur de canal. Il va servir de référence de courant.

Si le transistor T5 est à canal N (cas de la figure), sa source est reliée à Vss. Si c'était un transistor à canal P sa source serait reliée à Vdd.

Le courant dans le transistor T5 est recopié par effet de miroir de courant dans un sixième transistor T6 de même type, ayant sa grille et sa source reliées respectivement à la grille et la source de T5.

Le transistor T6 est en série avec un septième transistor T7 de type opposé, monté en diode (grille reliée à son drain). Ces deux transistors sont montés en série entre les deux conducteurs d'alimentation Vdd et Vss. La source de l'un est reliée à Vss et la source de l'autre à Vdd.

Les transistors T5 et T7 servent de références pour les courants dans les troisième et quatrième transistors T3 et T4. Des montages en miroir de courant entre ces quatre transistors pris deux à deux sont prévus à cet effet. Bien entendu, les transistors sont associés par paires de même type pour que la recopie de courant soit possible : si le troisième transistor T3 est de type P il doit recopier le courant d'un transistor de type P. Dans le cas de la figure c'est le transistor T7, mais si T5 était de type P, ce serait le transistor T6 qui serait de type P et qui servirait de référence au quatrième transistor, T7 étant de type N et servant de référence pour le transistor T3.

Dans l'exemple de la figure le transistor T3 est monté en miroir de courant pour recopier le courant dans T7, c'est-à-dire que T3 a sa source et sa grille reliées respectivement à la source et à la grille de T7.

De même, T4 a sa grille reliée à la grille de T6 et de T5 et sa source relié à la source de T6.

Les rapports de recopie sont choisis de telle manière que les courants dans T3 et T4 soient égaux, l'un entrant et l'autre sortant. Comme on le sait, les rapports de recopie sont les rapports de géométrie des transistors; la géométrie d'un transistor s'exprime par son rapport largeur sur longueur de canal. Cela veut dire que le rapport entre les géométries de T5 et T4 doit être le même que le rapport entre les géométries de T7 et T3.

Lorsque la tension d'alimentation est bruitée, ces rapports sont conservés et par conséquent le courant entrant reste égal au courant sortant même si sa valeur absolue change très légèrement. Le point de polarisation de l'étage amplificateur ne subit donc pas une modulation correspondant au bruit présent sur l'alimentation.

L'amplificateur selon l'invention peut comprendre un deuxième étage avec une autre paire de transistors complémentaires T8 et T9, semblable à la paire T1, T2, alimentée en courant de manière identique par un transistor T10 (courant entrant) et un transistor T11 (courant sortant). Le courant entrant est rendu égal au courant sortant de la même manière que pour le premier étage, et il n'est pas nécessaire de prévoir d'autres transistors pour établir les références de courant : les transistors T5, T6 et T7 servent de référence également pour le deuxième étage : le transistor T10, s'il est de type p, recopie le courant du transistor de même type (T7 dans l'exemple de la figure); pour cela sa source et sa grille sont reliées à la source et la grille respectivement de T7. De même pour le transistor T11 qui recopie le courant dans T5.

L'entrée du deuxième étage (grilles réunies de T8 et T9) est reliée à la sortie du premier étage (drains de T1 et T2). La sortie est prise sur les drains réunis de T8 et T9.

On notera que dans l'exemple de la figure on n'a pas prévu de résistance de contre réaction entre la sortie et l'entrée du deuxième étage.

Les dimensions des transistors du deuxième étage sont calculées afin d'avoir un gain maximum au repos pour cet étage.

Un troisième étage peut être prévu pour obtenir en sortie des niveaux compatibles avec les niveaux CMOS classiques. Cet étage final n'a pas besoin d'alimentation à travers deux générateurs de courant comme le premier et éventuellement le second : la paire complémentaire T12, T13 qui le constitue est connectée directement entre les conducteurs A et B comme un étage inverseur classique.

La sortie S de l'amplificateur est prise à la sortie du dernier étage.

On peut imaginer également d'autres dispositions avec un plus grand nombre d'étages, par exemple un étage supplémentaire entre les deuxième et troisième étages.

## Revendications

1. Amplificateur analogique en circuit intégré ayant une entrée connectée à une broche d'entrée (E) du circuit intégré, l'amplificateur analogique étant alimenté par un premier conducteur d'alimentation (A) et un deuxième conducteur d'alimentation (B) communs à une partie logique et une partie analogique du circuit intégré, et comportant au moins un étage amplificateur, caractérisé en ce que les problèmes de perturbation du fonctionnement de l'amplificateur analogique par les bruits engendrés par la partie logique et transmis par les conducteurs d'alimentation communs sont éliminés par le montage suivant :
- un étage amplificateur comportant un inverseur constitué d'une paire de transistors MOS complémentaires avec un premier transistor MOS (T1) et un deuxième transistor MOS (T2) montés en série, leurs grilles étant réunies ensemble à une entrée de l'étage amplificateur, leurs drains étant réunis ensemble à une sortie de l'étage amplificateur, l'étage amplificateur comportant en outre un troisième transistor MOS (T3) pour imposer un courant entrant dans l'inverseur et monté en série entre le premier conducteur d'alimentation (A) et la source du premier transistor MOS (T1), et un quatrième transistor MOS (T4) pour imposer un courant sortant de l'inverseur et monté en série entre le deuxième conducteur d'alimentation et la source du deuxième transistor MOS (T2),
- un étage de référence de courant comportant une première branche entre le premier et le deuxième conducteur d'alimentation, avec une résistance (R2) en série avec un cinquième transistor MOS (T5) monté en diode,
- et une deuxième branche avec un sixième transistor MOS (T6) et un septième transistor MOS (T7) montés en série entre le premier et le deuxième conducteur d'alimentation, le septième transistor MOS (T7) étant monté en diode et le sixième transistor MOS (T6) étant monté en miroir de courant par rapport au cinquième transistor MOS (T5) pour imposer un courant de référence dans le septième transistor MOS (T7),
- le troisième transistor MOS (T3) et le quatrième transistor MOS (T4) de l'étage amplificateur étant respectivement montés en miroir de courant par rapport au septième transistor MOS (T7) et au cinquième transistor MOS (T5) en sorte que le courant entrant imposé par le troisième transistor MOS (T3) soit égal au courant sortant imposé par le quatrième transistor MOS (T4).

2. Amplificateur analogique en circuit intégré selon la revendication 1, caractérisé en ce qu'une résistance de contre-réaction (R1) est placée entre l'entrée et la sortie de l'étage amplificateur.

3. Amplificateur analogique en circuit intégré selon l'une des revendications 1 et 2 précédentes, caractérisé en ce qu'il comporte deux étages amplificateurs en série comportant chacun un inverseur avec une paire de transistors MOS complémentaires, un transistor MOS pour imposer un courant entrant dans l'inverseur et un autre transistor MOS pour imposer un courant sortant de l'inverseur.

4. Amplificateur analogique en circuit intégré selon la revendication 3, caractérisé en ce que l'étage de référence de courant comportant la résistance (R2) et les cinquième, sixième et septième transistors MOS (T5, T6, T7) est commun aux deux étages amplificateurs.

5. Amplificateur analogique en circuit intégré selon la revendication 4 précédente, caractérisé en ce qu'il comporte un étage de sortie avec un inverseur comportant une paire de transistors MOS complémentaires.

## Patentansprüche

1. Analogverstärker in integrierter Schaltung, aufweisend einen mit dem Eingangsanschluß (E) der integrierten Schaltung verbundenen Eingang, wobei der Analogverstärker durch einen ersten Versorgungsleiter (A) und einen zweiten Versorgungsleiter (B) versorgt wird, gemeinsam einem Logikteil und einem Analogteil der integrierten Schaltung, und umfassend wenigstens eine Verstärkerstufe, dadurch **gekennzeichnet,** daß die Störungsprobleme der Funktion des Analogverstärkers durch Rauschen, erzeugt durch den Logikteil und übertragen durch die gemeinsamen Versorgungsleiter, durch die folgende Schaltungsanordnung beseitigt sind:
- eine Verstärkerstufe, umfassend ein Invertierglied, bestehend aus einem Paar von komplementären MOS-Transistoren mit einem ersten MOS-Transistor (T1) und einem zweiten MOS-Transistor (T2), die in Reihe geschaltet sind, wobei ihre Steuerelektroden zusammen an einem Eingang der Verstärkerstufe vereinigt sind, wobei ihre Drains zusammen an einem Ausgang der Verstärkerstufe vereinigt sind, wobei die Verstärkerstufe außerdem einen dritten MOS-Transistor (T3) zum Aufbringen eines Eingangsstroms in das Invertierglied und in Reihe zwischen dem ersten Versorgungsleiter (A) und der Source des ersten MOS-Transistors (T1) geschaltet und einen vierten MOS-Transistor (T4) zum Aufbringen eines Ausgangsstroms des Invertierglieds und in Reihe zwischen dem zweiten Versorgungsleiter und der Source des zweiten MOS-Transistors (T2) geschaltet umfaßt,
- eine Referenzstromstufe, umfassend einen ersten Zweig zwischen dem ersten und dem zweiten Versorgungsleiter mit einem Widerstand (R2) in Reihe mit einem als Diode geschalteten fünften MOS-Transistor (T5),
- und einen zweiten Zweig mit einem sechsten MOS-Transistor (T6) und einem siebten MOS-Transistor (T7), die zwischen dem ersten und dem zweiten Versorgungsleiter in Reihe geschaltet sind, wobei der siebte MOS-Transistor (T7) als Diode geschaltet ist und der sechste MOS-Transistor (T6) als Stromspiegel in bezug auf den fünften MOS-Transistor (T5) geschaltet ist, um einen Referenzstrom im siebten MOS-Transistor (T7) aufzubringen,
- wobei der dritte MOS-Transistor (T3) und der vierte MOS-Transistor (T4) der Verstärkerstufe jeweils als Stromspiegel in bezug auf den siebten MOS-Transistor (T7) und den fünften MOS-Transistor (T5) geschaltet sind derart, daß der durch den dritten MOS-Transistor (T3) aufgebrachte Strom gleich dem durch den vierten MOS-Transistor (T4) aufgebrachten Ausgangsstrom ist.

2. Analogverstärker in integrierter Schaltung nach Anspruch 1, dadurch **gekennzeichnet,** daß zwischen dem Eingang und dem Ausgang der Verstärkerstufe ein Gegenkopplungswiderstand (R1) angeordnet ist.

3. Analogverstärker in integrierter Schaltung nach einem der vorhergehenden Ansprüche 1 und 2, dadurch **gekennzeichnet,** daß er zwei Verstärkerstufen in Reihe, umfassend jeweils ein Invertierglied mit einem Paar komplementärer MOS-Transistoren, einen MOS-Transistor zum Aufbringen eines Eingangsstroms im Invertierglied und einen weiteren MOS-Transistor zum Aufbringen eines Ausgangsstroms des Invertiergliedes, umfaßt.

4. Analogverstärker in integrierter Schaltung nach Anspruch 3, dadurch **gekennzeichnet**, daß die Stromreferenzstufe, die den Widerstand (R2) und den fünften, sechsten und siebten MOS-Transistor (T5, T6, T7) umfaßt, den beiden Verstärkerstufen gemeinsam ist.

5. Analogverstärker in integrierter Schaltung nach dem vorhergehenden Anspruch 4, dadurch **gekennzeichnet**, daß er eine Ausgangsstufe mit einem Invertierglied umfaßt, umfassend ein Paar komplementärer MOS-Transistoren.

## Claims

1. Integrated-circuit analogue amplifier having an input connected to an input pin (E) of the integrated circuit, the analogue amplifier being powered by a first power supply conductor (A) and a second power supply conductor (B) both common to a logic part and an analogue part of the integrated circuit, and including at least one amplifier stage, characterised in that the problems of interference with the operation of the analogue amplifier by the noise generated by the logic part and transmitted by the common power supply conductors are eliminated by means of the following circuit:
- an amplifier stage including an inverter consisting of a pair of complementary MOS transistors with a first MOS transistor (T1) and a second MOS transistor (T2) mounted in series, their gates being connected together to an input of the amplifier stage, their drains being connected together to an output of the amplifier stage, the amplifier stage also including a third MOS transistor (T3) for determining a current entering the inverter and mounted in series between the first power supply conductor (A) and the source of the first MOS transistor (T1), and a fourth MOS transistor (T4) for determining a current coming from the inverter and mounted in series between the second power supply conductor and the source of the second MOS transistor (T2),
- a current-reference stage having a first arm between the first and second power supply conductors, with a resistor (R2) in series with a fifth MOS transistor (T5) mounted as a diode, and
- a second arm with a sixth MOS transistor (T6) and a seventh MOS transistor (T7) mounted in series between the first and second power supply conductors, the seventh MOS transistor (T7) being mounted as a diode and the sixth MOS transistor (T6) being mounted as a current mirror with respect to the fifth MOS transistor (T5) for determining a reference current in the seventh MOS transistor (T7),
- the third MOS transistor (T3) and the fourth MOS transistor (T4) of the amplifier stage being respectively mounted as a current mirror with respect to the seventh MOS transistor (T7) and to the fifth MOS transistor (T5) so that the incoming current determined by the third MOS transistor (T3) is equal to the outgoing current determined by the fourth MOS transistor (T4).

2. Integrated-circuit analogue amplifier according to Claim 1, characterised in that a negative-feedback resistor (R1) is placed between the input and output of the amplifier stage.

3. Integrated-circuit analogue amplifier according to one of the preceding Claims 1 and 2, characterised in that it includes two amplifier stages in series, each including an inverter with a pair of complementary MOS transistors, one MOS transistor for determining a current entering the inverter and another MOS transistor for determining a current leaving the inverter.

4. Integrated-circuit analogue amplifier according to Claim 3, characterised in that the current-reference stage including the resistor (R2) and the fifth, sixth and seventh MOS transistors (T5, T6, T7) is common to the two amplifier stages.

5. Integrated-circuit analogue amplifier according to the above Claim 4, characterised in that it includes an output stage with an inverter including a pair of complementary MOS transistors.
